# EUROPEAN PATENT APPLICATION

(11) **EP 4 651 378 A1**
(43) Date of publication of application: **19.11.2025**
(21) Application number: 23916369.4
(22) Date of filing: 25.05.2023
(51) Int. Cl.: H03K 17/693, H03K 17/691, H03K 17/687, H01F 30/16

(54) **SWITCH STACKING CIRCUIT AND SWITCH STACKING DEVICE COMPRISING SAME**

(30) Priority: 09.01.2023 KR 20230002994
(71) Applicant: Korea Electrotechnology Research Institute, Changwon-si, Gyeongsangnam-do 51543 (KR)
(72) Inventor: JANG, Sung Roc, Changwon-si, Gyeongsangnam-do 51543 (KR); KIM, Hyoung Suk, Changwon-si, Gyeongsangnam-do 51543 (KR); YU, Chan Hun, Changwon-si, Gyeongsangnam-do 51543 (KR); AN, Suk Ho, Pohang-si, Gyeongsangbuk-do 51543 (KR)
(74) Representative: Cabinet Beau de Loménie
(86) International application number: PCT/KR2023/007149
(87) International publication number: WO 2024/150885

(57) **Abstract**

Disclosed are a switch stacking circuit in which a plurality of switch devices is stacked in series, and a switch stacking device including the same. The switch stacking circuit includes a first switch group of N switch devices (S1, ..., SN, where N is a natural number greater than or equal to 1) connected in series to each other through a first wiring (W1), and a second switch group of M switch devices (S1, ..., SM, where M is a natural number greater than or equal to 1) connected in series to each other through a second wiring (W2), wherein the first switch group and the second switch group are connected in series to each other, and when a drive signal is applied to the first switch group and the second switch group, a direction of electric current flowing in the first wiring (W1) is opposite to a direction of electric current flowing in the second wiring (W2).

## Description

### [Technical Field]

The present invention relates to a switch stacking circuit in which a plurality of switch devices is stacked in series, and a switch stacking device including the same.

### [Background Art]

A pulse is a short duration high intensity signal and a pulse of large power (high voltage) can be applied to a load terminal by instantaneously discharging stored energy.

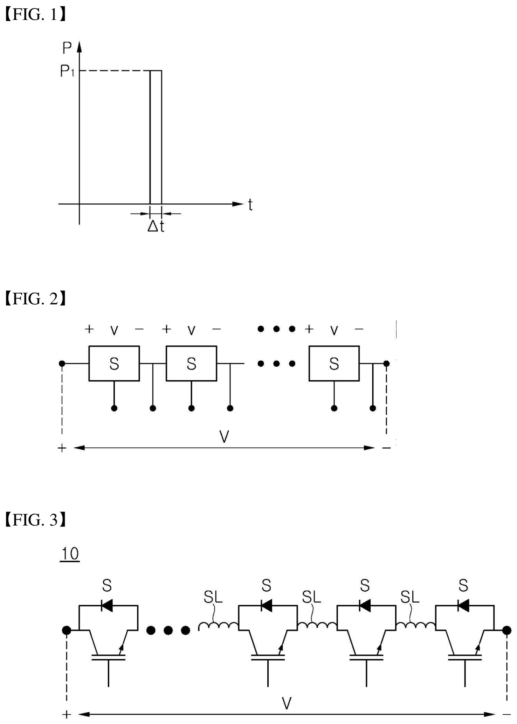

By way of example, a pulse of large power P1 applied for a short interval (Δt) is shown in FIG. 1.

A conventional technique capable of generating such pulses includes a circuit that stores a large amount of energy in an energy storage device, such as a capacitor, and then discharges the energy to the load terminal when a switch is turned on.

Although gas switches (spark gap, thyratron) with high voltage and current ratings have been used in the related art, such switches suffer from technical problems, such as limited lifespan, difficulty in control, jitter, and the like.

As a result, various studies have been made to employ power semiconductor switches, such as IGBTs, MOSFETs, thyristors, and the like, for generation of pulse power.

For example, IGBTs have an extremely long lifespan and can overcome disadvantages of conventional mechanical switches, thereby enabling control of pulse repetition rate and pulse width.

However, IGBTs also have strict operational constraints regarding switch driving and uniform voltage distribution, which can cause reliability issues in products. Moreover, there are limitations in rated voltage and rated current of commercially available power semiconductor devices. Therefore, there is a need to develop series-parallel stacking technology for power semiconductor devices to generate high-voltage high-current pulses.

In particular, there is a need for a structure capable of minimizing stray inductance generated by wiring required in a process of connecting multiple switch devices in series. Conventionally, stray inductance limits a rising time of pulse current due to stray inductance, thereby restricting application of large-scale switches employing semiconductor devices.

### [Disclosure]

### [Technical Problem]

It is an object of the present invention to provide a switch stacking circuit capable of minimizing stray inductance generated by wiring in a process of connecting switch devices stacked in series, and a switch stacking device including the same.

### [Technical Solution]

In accordance with one aspect of the present invention, there is provided a switch stacking circuit (100) including: a first switch group (G1) having N switch devices (S1, ..., SN, where N is a natural number greater than or equal to 1) connected in series to each other through a first wiring W1; and a second switch group (G2) having M switch devices (S1, ..., SM, where M is a natural number greater than or equal to 1) connected in series to each other through a second wiring (W2).

The first switch group (G1) and the second switch group (G2) may be connected in series to each other.

When a drive signal (Vd) is applied to the first switch group (G1) and the second switch group (G2), a direction of electric current flowing in the first wiring (W1) may be opposite to a direction of electric current flowing in the second wiring (W2).

The number of switch devices (N) in the first switch group (G1) may be the same as the number of switch devices (M) in the second switch group (G2.

The first switch group (G1) and the second switch group (G2) may be connected in series to each other through a third wiring (W3).

The first switch group (G1) and the second switch group (G2) may be arranged in two parallel rows.

An insulating member (110) may be disposed between the first switch group (G1) and the second switch group (G2) for insulation therebetween.

The switch stacking circuit (100) may further include a drive module (120) configured to apply the drive signal (Vd) to the first switch group (G1) and the second switch group (G2).

The drive module (120) may include a first drive circuit (122) for applying the drive signal (Vd) to the first switch group (G1) and a second drive circuit (124) for applying the drive signal (Vd) to the second switch group (G2).

The first drive circuit (122) may include N first drive units (122_1, ..., 122_N) corresponding to the N switch devices (S1, ..., SN), respectively.

The second drive circuit (124) may include M second drive units (124_1, ..., 124_M) corresponding to the M switch devices (S1, ..., SM), respectively.

The switch stacking circuit (100) may further include a generator (130) configured to generate drive pulses (Pon, Poff) for on/off control of the drive signal (Vd).

The switch stacking circuit (100) may further include a transformer module (140) configured to simultaneously transmit isolated drive power between the generator (130) and the drive module (120).

The transformer module (140) may include N first transformer units (142_1, ..., 142_N) disposed corresponding to the N first drive units (122_1, ..., 122_N) and M second transformer units (144_1, ..., 144_M) disposed corresponding to the M second drive units (124_2, ..., 124_M).

In accordance with another aspect of the present invention, there is provided a switch stacking device (200) including the switch stacking circuit (100), wherein the switch stacking device (200) includes: a first stack (210) on which the N switch devices (S1, ..., SN) of the first switch group (G1) are disposed; and a second stack (220) on which the M switch devices (S1, ..., SM) of the second switch group (G2) are disposed.

The first stack (210) and the second stack (220) may be disposed to face each other with a clearance therebetween.

An insulating member (110) may be disposed between the first stack (210) and the second stack (220) for insulation therebetween.

The first stack (210) may include a first circuit board (PCB) on which N switch devices (S1, ..., SN) are disposed, and a first frame (214) on which the first circuit board (PCB) is secured to a first surface of the first frame (214).

The second stack (220) may include a second circuit board (PCB) on which the M switch devices (S1, ..., SM) are disposed, and a second frame (224) on which the second circuit board (PCB) is secured to a first surface of the second frame (224).

The first circuit board (PCB) and the second circuit board (PCB) may be disposed to face each other with a clearance therebetween.

The switch stacking device (200) may further include a first heat sink (310) disposed on a second surface of the first frame (214) opposite the first surface thereof and a second heat sink (320) disposed on a second surface of the second frame (224) opposite the first surface thereof.

The switch stacking circuit (100) may further include: a drive module (120) configured to apply a drive signal (Vd) to the first switch group (G1) and the second switch group (G2); a generator (130) configured to generate drive pulses (Pon, Poff) for on/off control of the drive signal (Vd); and a transformer module (140) configured to simultaneously transmit isolated drive power between the generator (130) and the drive module (120).

The transformer module (140) may include a primary coil (C1) connected to the generator (130), a secondary coil (C2) connected to the drive module (120), and a transformer core (TC) for mutually inductive coupling between the primary coil (C1) and the secondary coil (C2).

The transformer core (TC) may be a toroidal core with a through-hole (H) formed in a center thereof.

### [Advantageous Effects]

Embodiments of the present invention provide a switch stacking circuit capable of minimizing stray inductance generated by wiring in a process of connecting switch devices stacked in series, and a switch stacking device including the same.

By providing a circuit and device structure that minimizes stray inductance, the present invention has an advantage of solving the problem of delaying a pulse rise rate due to stray inductance, thereby significantly expanding application fields of large-scale switches employing semiconductor switch devices.

### [Description of Drawings]

FIG. 1 is a graph showing pulse power generated by a switch stacking circuit according to one embodiment of the present invention.
FIG. 2 is a schematic diagram of a structure in which a plurality of switch devices is stacked in series to generate pulse power.
FIG. 3 is a schematic diagram of stray inductance generated by wiring in a process of connecting switch devices in series.
FIG. 4 is a block diagram of a typical switch device stacking circuit.
FIG. 5 is a graph showing a relationship between an on/off signal and a drive signal for driving a switch device stacking circuit according to the present invention.
FIG. 6 is a schematic diagram illustrating switch devices connected in series in the switch stacking circuit according to the present invention.
FIG. 7 is a block diagram of the switch stacking circuit including the switch devices connected in series in FIG. 6.
FIG. 8A and FIG. 8B are a plan view and a perspective view of a switch stacking device including the switch stacking circuit of FIG. 7.
FIG. 9A and FIG. 9B are a plan view and a perspective view of a switch stacking device including the switch stacking circuit of FIG. 7.

### [Best Mode]

Hereinafter, exemplary embodiments of the present invention will be described in detail with reference to the accompanying drawings.

A switch stacking circuit 100 according to the present invention may include a first switch group G1 having N switch devices (S1, ..., SN, where N is a natural number greater than or equal to 1) connected in series to each other through a first wiring W1, and a second switch group G2 having M switch devices (S1, ..., SM, where M is a natural number greater than or equal to 1) connected in series to each other through a second wiring W2.

The first switch group G1 may include N switch devices S1, ..., SN connected in series to each other through the first wiring W1.

The second switch group G2 may include M switch devices S1, ..., SM connected in series to each other through the second wiring W2.

Preferably, the number N of switch devices S1, ..., SN included in the first switch group G1 is the same as the number M of switch devices S1, ..., SM included in the second switch group G2, without being limited thereto.

The first switch group G1 and the second switch group G2 may be connected in series to each other.

That is, the switch device SN placed at a distal end of the first switch group G1 may be connected in series to the switch device SM placed at a distal end of the second switch group G2 through a third wiring W3.

The switch devices S1 to SN, S1 to SM are power semiconductor devices and may be composed of various semiconductor devices, such as an SCR (thyristor), a TRIAC (triode AC switch), a GTO (gate turn-off thyristor), an IGBT (Insulated Gate Bipolar Transistor), a MOSFET (Metal Oxide Semiconductor Field Effect Transistor), and the like, without being limited thereto.

For example, the switch devices S1 to SN, S1 to SM may be IGBTs.

When the switch devices S1 to SN, S1 to SM are IGBTs, each of the switch devices is formed with three terminals, that is, a gate G, a collector C, and an emitter E, and may be turned on or off by a driving signal Vd (Vge) applied to the gate G.

As another example, when the switch devices S1 to SN, S1 to SM are MOSFETs, each of the switch devices is formed with three terminals, that is, a gate G, a drain D, and a source S, and may be turned on or off by a driving signal Vd (Vgs) applied to the gate G.

As the switch devices S1 to SN, S1 to SM are connected in series to each other and operated in synchronization, voltages applied to the switch device S1 to SN, S1 to SM are summed and a high-voltage pulse P1 is finally generated between both ends of a load.

FIG. 2 shows that a plurality of switch devices S is connected in series such that a voltage v is generated between both ends of each of the switch devices S and a high voltage V is finally generated between both ends of a series-connection circuit.

The first switch group G1 and the second switch group G2 will be described in more detail after description of the drive module 120 and the generator 130 of the switch stacking circuit 100.

The drive module 120 is configured to apply a drive signal Vd to the switch devices S1 to SN, S1 to SM and may have various configurations.

The drive module 120 may be configured to simultaneously apply the drive signal Vd to each of the first switch group G1 and the second switch group G2.

The drive module 120 may include a first drive circuit 122 for applying the drive signal Vd to the first switch group G1 and a second drive circuit 124 for applying the drive signal Vd to the second switch group G2.

The first drive circuit 122 may include N first drive units 122_1, ..., 122_N corresponding to the N switch devices S1, ..., SN to provide isolated power to the switch devices S1, ..., SN, respectively.

The N first drive units 122_1, ..., 122_N may output a drive signal Vd to be applied to the corresponding switch devices S1, ..., SN in response to a control signal Vp from a generator 130 described below.

Similarly, the second drive circuit 124 may include M second drive units 124_1, ..., 124_M corresponding to the M switch devices S1, ..., SM to provide isolated power to the switch devices S1, ..., SM, respectively.

The M second drive units 124_1, ..., 124_M may output a drive signal Vd to be applied to the corresponding switch devices S1, ..., SM in response to a control signal Vp from the generator 130 described below.

The first drive units 122_1, ..., 122_N and the second drive units 124_1, ..., 124_N may have the same or similar configuration, preferably the same circuit structure.

The generator 130 may be configured to generate drive pulses Pon, Poff for control on/off control of the drive signal (Vd) and may have various configurations.

For example, the generator 130 may include a pulse generator that generates pulses for on/off control to generate a drive signal Vd to be applied to the switch devices S1 to SN, S1 to SM, and an inverter that outputs a switching signal for the drive module 120 in response to an output signal from the pulse generator. However, it should be understood that this structure is provided by way of example and the present invention is not limited thereto.

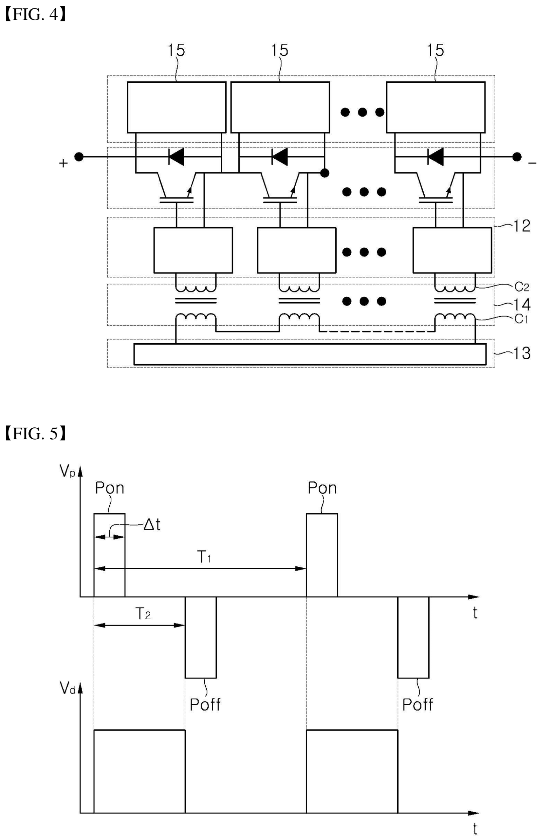

The pulse generator may be configured to generate drive pulses for on/off control to generate the drive signal Vd, and may generate on-pulse (Pon) and off-pulse (Poff) signals each having a short width (Δt) as pulses for on/off control, as shown in FIG. 5.

The inverter may be configured to output a switching signal for the plurality of first drive units 122_1, ..., 122_N and the plurality of second drive units 124_1, ..., 124_M in response to an output signal from the pulse generator, and may have various configurations. For example, the inverter may be configured as a full bridge circuit including four switch devices, without being limited thereto.

The on-pulse (Pon) and off-pulse (Poff) signals of the pulse generator may be transmitted to each of the first drive units 122_1, ..., 122_N) and the second drive units 124_1, ..., 124_M through a transformer module 140 described below for driving and insulation of switches of the inverter.

For example, the pulse generator corresponds to an on/off signal generator for outputting the drive pulses Pon, Poff for on/off control of the drive signal Vd, and may include an on-pulse generator for generating an on-pulse Pon for turning the drive signal Vd on and an off-pulse generator for generating an off-pulse Poff for turning the drive signal Vd off.

Referring to FIG. 5, the on-pulse Pon is a pulse signal with a short width Δt and a period of T1 generated from the on-pulse generator.

Similarly, the off-pulse Poff is a pulse signal with a short width Δt and a period of T1 generated from the off-pulse generator.

The on-pulse generator and the off-pulse generator alternately generate the on-pulse Pon and the off-pulse Poff at a time interval T2 such that the drive signal Vd can be maintained for a preset period of time.

When the on-pulse Pon is generated, the drive signal Vd is generated from each of the first drive units 122_1, ..., 122_N and the second drive units 124_1, ..., 124_M, and, even when the on-pulse Pon generated for a short period of time Δt disappears, the drive signal Vd may be maintained by an electrical device (for example, a holding capacitor) provided in each of the first drive units 122_1, ..., 122_N and the second drive units 124_1, ..., 124_M.

The drive signal Vd may be maintained and turned off by the off-pulse Poff in response to generation of the off-pulse Poff.

That is, a drive signal Vd with a relatively long width T2 may be generated by the on-pulse (Pon) and the off-pulse (Poff) each having a short width (Δt) by each of the first drive units 122_1, ..., 122_N and the second drive units 124_1, ..., 124_M.

As a result, the switch device stacking circuit 100 according to the present invention has an advantage of reducing the size of the transformer module 140 that transmits signals to each of the first drive units 122_1, ..., 122_N and the second drive units 124_1, ..., 124_M, while securing isolated power between the switch devices S1 to SN, S1 to SM.

The transformer module 140 is a transformer for simultaneously transmitting isolated drive power between the generator 130 and the drive module 120, and may have various configurations.

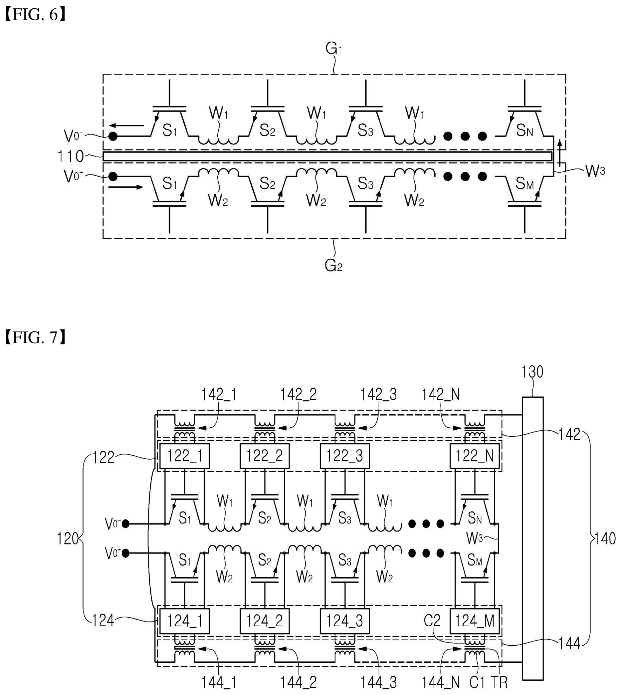

Referring to FIG. 7, the transformer module 140 may include N first transformer units 142_1, ..., 142_N disposed corresponding to the N first drive units 122_1, ..., 122_N, and M second transformer units 144_1, ..., 144_M disposed corresponding to the M second drive units 124_2, ..., 124_M.

The first transformer unit 142_1, ..., 142_N and the second transformer unit 144_1, ..., 144_M may have the same or similar configuration, preferably the same circuit structure.

Each of the first transformer units 142_1, ..., 142_N and the second transformer units 144_1, ..., 144_M may include a primary coil C1 connected to the generator 130, a secondary coil C2 connected to the drive module 120, and a transformer core TC for mutual inductive coupling between the primary coil C1 and the secondary coil C2.

An output terminal of the generator 130 may be connected to the primary coil C1 of each of the first transformer units 142_1, ..., 142_N and the second transformer units 144_1, ..., 144_M.

N primary coils C1 included in the N first transformer units 142_1, ..., 142_N may be connected in series to the M second transformer units 144_1, ..., 144_M.

An input terminal of the drive module 120 may be connected to the secondary coil C2 of each of the first transformer units 142_1, ..., 142_N and the second transformer units 144_1, ..., 144_M.

Specifically, the N first drive units 122_1, ..., 122_N may be connected to the secondary coils C2 of the corresponding first transformer units 142_1, ..., 142_N, respectively, and the M second drive units 124_1, ..., 124_M may be connected to the secondary coils C2 of the corresponding second transformer units 144_1, ..., 144_M, respectively.

A signal output from the output terminal of the generator 130 may be transformed through the primary coil C1 and the secondary coil C2 of each of the transformer units 142_1 to N, 144_1 to M to be applied to each of the drive units 122_1 to N, 124_1 to M.

The transformer core TC may have various configurations for mutually inductive coupling between the primary coil C1 and the secondary coil C2 and the number of transformer cores TC may correspond to the number (N+M) of transformer units 142_1 to N, 144_1 to M.

For example, the transformer core TC may be a toroidal core, without being limited thereto.

The switch stacking circuit 100 according to the present invention may further include a voltage balancing unit 150 configured to maintain voltage balance between the switch devices S1 to SN, S1 to SM while preventing overvoltage to a particular switch device S1 to SN, S1 to SM.

The voltage balancing unit 150 may include a snubber circuit, without being limited thereto.

On the other hand, FIG. 3 and FIG. 4 illustrate a structure of a typical switch stacking circuit 10, in which a stray inductance SL may be generated by wiring W for series connection in a process of connecting a plurality of switch devices S in series.

When an influence of the stray inductance SL component becomes significant, the stray inductance SL component makes fast switching difficult and becomes a main cause of overvoltage conditions and switching loss due to current delay upon turning the switch device S off. Accordingly, various hardware configurations are required to reduce the stray inductance (SL).

FIG. 4 is a schematic diagram for illustrating a switch stacking circuit 10 according to the switch series connection structure of FIG. 3, in which a large number of switch devices S is linearly connected in series, and it can be seen that the stray inductance SL can significantly influence the connection structure.

In FIG. 4, reference numerals 12, 13, 14, and 15 denote a drive module 12 for driving a plurality of switch devices S, a generator 13, a transformer module 14, and a voltage balancing circuit 15, respectively. These components may have the same or similar configurations to the drive module 120, the generator 130, the transformer module 140, and the voltage balancing unit 150 described above.

On the other hand, the switch stacking circuit 100 according to the present invention may be configured such that, when a driving signal Vd is applied to the first switch group G1 and the second switch group G2, a direction of electric current flowing in the first wiring W1 is opposite to a direction of electric current flowing in the second wiring W2 in order to minimize the stray inductance SL generated by the wirings.

Referring to FIG. 6, it can be seen that electric current flowing through the first switch group G1 along the first wiring W1 flows in the leftward direction with respect to the drawing and the electric current flowing through the second switch group G2 along the second wiring W2 flows in the rightward direction opposite the leftward direction with respect to the drawing.

In the third wiring W3 that connects the switch device SN placed at the distal end of the first switch group G1 and the switch device SM placed at the distal end of the second switch group G2 in series, electric current may flow in an upward direction from a lower side to an upper side with reference to the drawing.

Since the direction of the electric current flowing along the first wiring W1 and the direction of the electric current flowing along the second wiring W2 are opposite to each other and are placed adjacent to each other, the influence of the electric current flowing along the first wiring W1 and the influence of the electric current flowing along the second wiring W2 are canceled out, and an inductance generated by the first wiring W1 and an inductance generated by the second wiring W2 are canceled out, thereby providing an effect of generating no stray inductance.

As shown in FIG. 6, the first switch group G1 and the second switch group G2 may be arranged in two rows, more preferably in two parallel rows. In particular, the first wiring W1 and the second wiring W2 may be arranged adjacent to each other.

FIG. 7 is a schematic diagram of a switch stacking circuit 100 including the first wiring W1 and the second wiring W2 as shown in FIG. 6.

Referring to FIG. 7, at the center, the first switch group G1 and the second switch group G2 are arranged in two rows, and the generator 130 may be disposed at one side of the third wiring W1 to which the first switch group G1 and the second switch group G2 are connected in series. Accordingly, output terminals Vo-, Vo+ of the switch stacking circuit 100 may be arranged side by side at the other side of the third wiring W3.

Furthermore, the switch devices S1 to SN of the first switch group G1 and the switch devices S1 to SM of the second switch group G2 may be arranged such that the first wiring W1 and the second wiring W2 are disposed adjacent to each other, and the drive module 120, the voltage balancing unit 150, and the transformer module 140 are disposed to face outwards.

Among these components, the transformer module 140 may be disposed along the outermost periphery to magnetically connect the generator 130 and the drive module 120 disposed at the third wiring W3 side.

Accordingly, the switch stacking circuit 100 may form a symmetrical circuit structure with respect to the first wiring W1 and the second wiring W2.

On the other hand, as shown in FIG. 6, since the first switch group G1 and the second switch group G2 are arranged in two rows to face each other, an insulating member 110 may be disposed between the first switch group G1 and the second switch group G2 for insulation therebetween.

As shown in FIG. 6, the first switch group G1 may be placed at one side of the insulating member 110 and the second switch group G2 may be placed at the other side thereof.

The insulating member 110 may be formed of various materials and shapes so long as insulation between the first switch group G1 and the second switch group G2 can be maintained.

For example, the insulating member 110 may be formed in a thin plate shape to minimize the size of the switch stacking circuit 100, without being limited thereto.

Although the insulating member 110 is omitted in FIG. 7, it is apparent from the above description that the insulating member 110 may be interposed between the first switch group G1 and the second switch group G2.

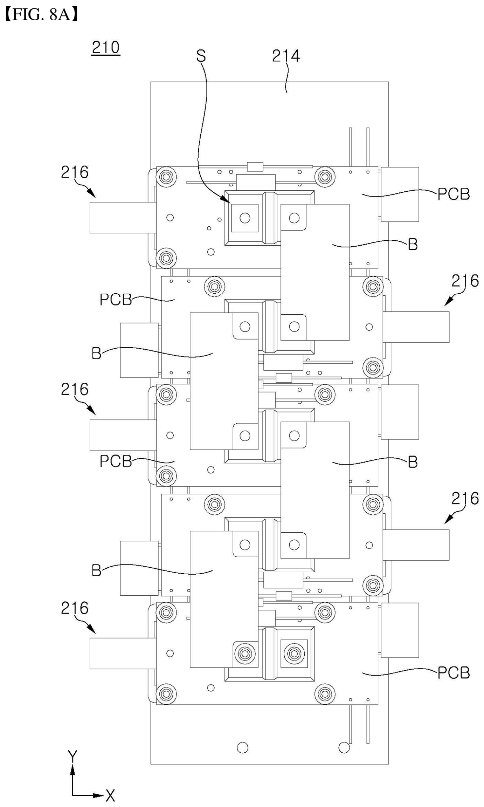

Next, with reference to FIG. 8A to FIG. 10C, a switch stacking device 200 including the switch stacking circuit 100 according to the present invention will be described in detail.

The switch stacking device 200 may include a first stack 210 on which the N switch devices S1, ..., SN of the first switch group G1 are disposed; and a second stack 220 on which the M switch devices S1, ..., SM of the second switch group G2 are disposed.

The first stack 210 is a frame on which the N switch devices S1, ..., SN of the first switch group G1 are disposed, and may have various configurations.

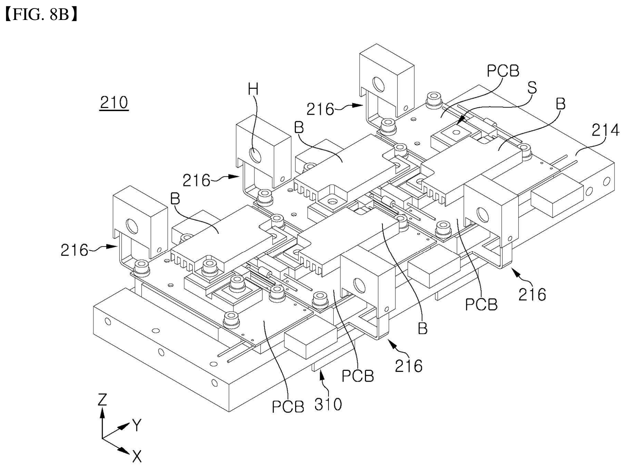

Referring to FIG. 8A and FIG. 8B, the first stack 210 may include a plurality of circuit boards (PCBs) on which the N switch devices S1, ..., SN are mounted, a first frame 214 to which the plurality of circuit boards (PCBs) is fixedly coupled, and a plurality of busbars B for electrical series connection between neighboring switch devices S1, ..., SN.

Each of the busbars B for electrical connection between the neighboring switch devices S1, ..., SN on the first frame 214 may be a connection member forming the first wiring W1 described above.

The busbars B may be formed in various shapes. For example, referring to FIG. 8A and FIG. 8B, the busbars B may be arranged in a two-row zigzag shape for compact arrangement.

The number of circuit boards (PCB) may correspond to the number (N) of switch devices S1, ..., SN.

Here, N circuit boards (PCBs) are secured to one surface of the first frame 214 and may be linearly arranged in a longitudinal direction of the first frame 214. A certain gap may be formed between neighboring circuit boards.

On each of the circuit boards (PCB), the first drive units 122_1, ..., 122_N of the corresponding drive module 120 and the voltage balancing unit 150 may be disposed. Furthermore, the transformer module 140 may be connected to one side of the circuit board PCB.

More specifically, the first transformer units 142_1, ..., 142_N of the corresponding transformer module 140 may be electrically connected and coupled to a side surface of each of the circuit boards (PCB).

Referring to FIG. 8A, the N first transformer units 142_1, ..., 142_N may be alternately arranged in two rows in a zigzag shape along opposite side surfaces of the first frame 214.

The first frame 214 may be a planar plate having a thickness to act as a support member on which the circuit boards (PCBs) and the N first transformer units 142_1, ..., 142_N are fixedly disposed, and may be formed in a polygonal shape, such as a square shape, in plan view.

The first frame 214 may be provided with the circuit boards (PCBs) on a first surface thereof and with a first heat sink 310 on a second surface thereof opposite the first surface.

The first heat sink 310 may have various configurations. For example, the first heat sink 310 may include a plurality of heat dissipation members (for example, heat dissipation fins) extending perpendicular to the second surface.

The second stack 220 is a frame on which the M switch devices S1, ..., SM of the second switch group G2 are disposed, and may have various configurations.

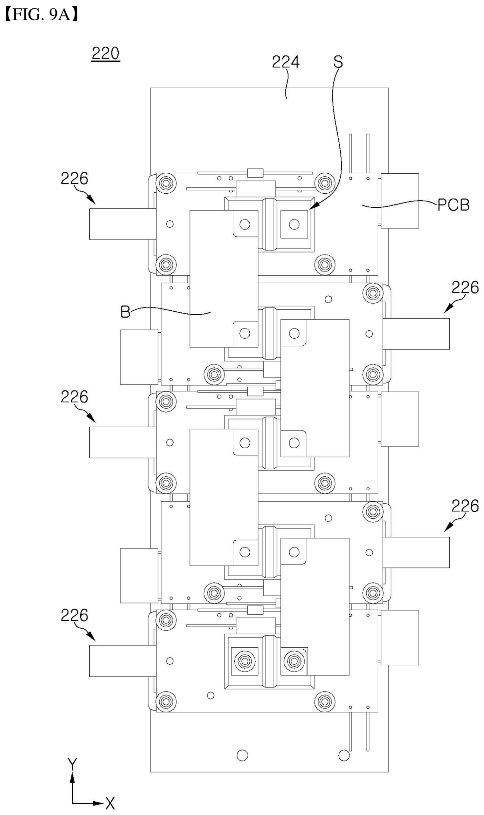

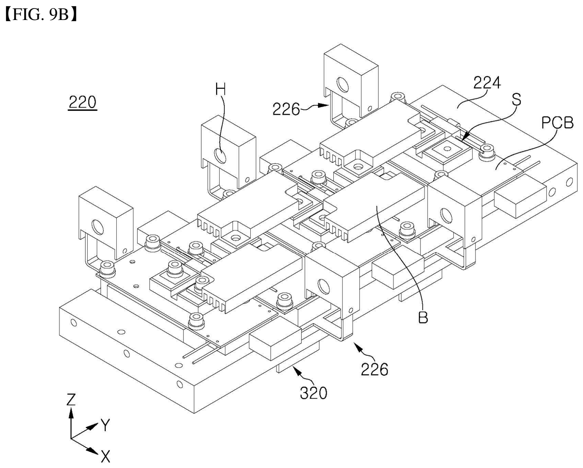

Referring to FIG. 9A and FIG. 9B, the second stack 220 may include a plurality of circuit boards (PCBs) on which the M switch devices S1, ..., SM are mounted, a second frame 224 to which the plurality of circuit boards (PCBs) is fixedly coupled, and a plurality of busbars B for electrical series connection between neighboring switch devices S1, ..., SM.

Each of the busbars B for electrical connection between the neighboring switch devices S1, ..., SM on the second frame 224 may be a connection member forming the second wiring W2 described above.

The busbars B may be formed in various shapes. For example, referring to FIG. 9A to FIG. 9B, the bus bars B may be arranged in a two-row zigzag shape for compact arrangement.

The number of circuit boards (PCB) may correspond to the number (M) of M switch devices S1, ..., SM.

Here, M circuit boards (PCBs) are secured to one surface of the second frame 224 and may be linearly disposed in a longitudinal direction of the second frame 224. A certain gap may be formed between neighboring circuit boards.

On each of the circuit boards (PCB), the second drive units 124_1, ..., 124_M of the corresponding drive module 120 and the voltage balancing unit 150 may be disposed. Furthermore, the transformer module 140 may be connected to one side of the circuit board PCB.

More specifically, the second transformer units 144_1, ..., 144_M of the corresponding transformer module 140 may be electrically connected and coupled to a side surface of each of the circuit boards (PCB).

Referring to FIG. 9A, the M second transformer units 144_1, ..., 144_M may be alternately arranged in two rows in a zigzag shape along opposite side surfaces of the second frame 224.

The second frame 224 may be a planar plate having a thickness to act as a support member on which the circuit boards (PCBs) and the M second transformer units 144_1, ..., 144_M are fixedly disposed, and may be formed in a polygonal shape, such as a square shape, in plan view.

The second frame 224 may be provided with the circuit boards (PCBs) on a first surface thereof and with a second heat sink 320 on a second surface thereof opposite the first surface.

The second heat sink 320 may have various configurations. For example, the second heat sink 320 may include a plurality of heat dissipation members (for example, heat dissipation fins) extending perpendicular to the second face.

It should be noted that the first stack 210 and the second stack 220 may have the same or similar configuration.

The first stack 210 and the second stack 220 may be disposed to face each other with a clearance therebetween. To this end, a housing or securing member (not shown) may be disposed for securing the first stack 210 and the second stack 220.

Here, a first surface of the first frame 214 of the first stack 210 and a first surface of the second frame 224 of the second stack 220 may be disposed to face each other.

As a result, the busbars B on the first frame 214 side and the busbars B on the second frame 224 side are disposed to face each other with a clearance therebetween, and the insulating member 110 may be disposed between the first stack 210 and the second stack 220, specifically between the first surface of the first frame 214 and the first surface of the second frame 224.

Here, the first transformer units 142_1, ..., 142_N disposed along the side surface of the first frame 214 may be disposed alternately with the second transformer units 144_1, ..., 144_M disposed along the side surface of the second frame 224 so as not to interfere with each other.

That is, as the second transformer units 144_1, ..., 144_M are located between neighboring first transformer units 142_1, ..., 142_N and the first transformer unit 142_1, ..., 142_N are located between neighboring second transformer units 144_1, ..., 144_M, the first frame 214 and the second frame 224 can form a more compact structure.

The transformer cores TC of the first transformer units 142_1, ..., 142_N and the transformer cores TC of the second transformer units 144_1, ..., 144_M may have the same or similar configuration. For example, each of the transformer cores TC may be a toroidal core having a through-hole (H) formed at a center thereof to allow a high-voltage cable to pass therethrough.

The transformer core TC may be wound with a secondary coil C2 electrically connected to the corresponding first drive unit 122_1, ..., 122_N or the corresponding second drive units 124_1, ..., 124_M.

The first frame 214 and the second frame 224 may be provided with core anchoring members 216, 226 to support and secure the transformer cores TC.

The core anchoring members 216, 226 are structures for securing the transformer cores TC, and may be, for example, a J-shaped structure. However, it should be understood that the core anchoring members are not limited thereto and may have various structures and shapes.

In addition, the switch stacking device 200 may further include a drive unit (not shown) fixedly disposed at one side of the first stack 210 or the second stack 220.

The drive unit (not shown) may include a circuit board (PCB) on which the generator 130 is disposed, and a drive unit housing (not shown) on which the circuit board (PCB) is disposed.

For example, the drive unit housing (not shown) may be secured to one end of the first frame 214 in a longitudinal direction thereof.

A high-voltage cable extending from the circuit board (PCB) of the drive unit (not shown) may pass through the through-hole (H) of the transformer core TC of the primary coil C1 and may be inductively coupled to the secondary coil (C2).

Although some exemplary embodiments have been described herein, it should be understood by those skilled in the art that these embodiments are given by way of illustration only and that various modifications, variations and alterations can be made without departing from the spirit and scope of the invention.

## Claims

1. A switch stacking circuit (100) comprising a first switch group (G1) of N switch devices (S1, ..., SN, where N is a natural number greater than or equal to 1) connected in series to each other through a first wiring (W1), and a second switch group (G2) of M switch devices (S1, ..., SM, where M is a natural number greater than or equal to 1) connected in series to each other through a second wiring (W2),
wherein the first switch group (G1) and the second switch group (G2) are connected in series to each other, and
when a drive signal (Vd) is applied to the first switch group (G1) and the second switch group (G2), a direction of electric current flowing in the first wiring (W1) is opposite to a direction of electric current flowing in the second wiring (W2).

2. The switch stacking circuit (100) according to claim 1, wherein
the number of switch devices (N) in the first switch group (G1) is the same as the number of switch devices (M) in the second switch group (G2).

3. The switch stacking circuit (100) according to claim 1, wherein
the first switch group (G1) and the second switch group (G2) are connected in series to each other through a third wiring (W3).

4. The switch stacking circuit (100) according to claim 1, wherein
the first switch group (G1) and the second switch group (G2) are arranged in two parallel rows.

5. The switch stacking circuit (100) according to claim 4, wherein an insulating member (110) is disposed between the first switch group (G1) and the second switch group (G2) for insulation therebetween.

6. The switch stacking circuit (100) according to claim 1, further comprising:
a drive module (120) configured to apply the drive signal (Vd) to the first switch group (G1) and the second switch group (G2).

7. The switch stacking circuit (100) according to claim 6, wherein
the drive module (120) comprises a first drive circuit (122) for applying the drive signal (Vd) to the first switch group (G1) and a second drive circuit (124) for applying the drive signal (Vd) to the second switch group (G2).

8. The switch stacking circuit (100) according to claim 7, wherein
the first drive circuit (122) comprises N first drive units (122_1, ..., 122_N) corresponding to the N switch devices (S1, ..., SN), respectively, and
the second drive circuit (124) comprises M second drive units (124_1, ..., 124_M) corresponding to the M switch devices (S1, ..., SM), respectively.

9. The switch stacking circuit (100) according to claim 8, further comprising:
a generator (130) configured to generate drive pulses (Pon, Poff) for on/off control of the drive signal (Vd).

10. The switch stacking circuit (100) according to claim 9, further comprising:
a transformer module (140) configured to simultaneously transmit isolated drive power between the generator (130) and the drive module (120).

11. The switch stacking circuit (100) according to claim 10, wherein
the transformer module (140) comprises N first transformer units (142_1, ..., 142_N) disposed corresponding to the N first drive units (122_1, ..., 122_N), and M first transformer units (144_1, ..., 144_M) disposed corresponding to the M second drive units (124_2, ..., 124_M).

12. A switch stacking device (200) including the switch stacking circuit (100) according to claim 1, wherein the switch stacking device (200) comprises a first stack (210) on which the N switch devices (S1, ..., SN) of the first switch group (G1) are disposed; and a second stack (220) on which the M switch devices (S1, ..., SM) of the second switch group (G2) are disposed.

13. The switch stacking device (200) according to claim 12, wherein
the first stack (210) and the second stack (220) are disposed to face each other with a clearance therebetween, and
an insulating member (110) is disposed between the first stack (210) and the second stack (220) for insulation therebetween.

14. The switch stacking device (200) according to claim 12, wherein
the first stack (210) comprises a circuit board (PCB) on which the N switch devices (S1, ..., SN) are disposed, and a first frame (214) on which the circuit board (PCB) is secured to a first surface of the first frame (214), and
the second stack 220 comprises a circuit board (PCB) on which the M switch devices (S1, ..., SM) are disposed, and a second frame (224) on which the circuit board (PCB) is secured to a first surface of the second frame (224).

15. The switch stacking device (200) according to claim 14, wherein
the circuit board (PCB) and the circuit board (PCB) are disposed to face each other with a clearance therebetween,
the switch stacking device (200) further comprising:
a first heat sink (310) mounted on a second surface of the first frame (214) opposite the first surface thereof, and a second heat sink (320) mounted on a second surface the second frame (224) opposite the first surface thereof.

16. The switch stacking device (200) according to claim 15, further comprising:
a drive module (120) configured to apply a drive signal (Vd) to the first switch group (G1) and the second switch group (G2); a generator (130) configured to generate drive pulses (Pon, Poff) for on/off control of the drive signal (Vd); and a transformer module (140) configured to simultaneously transmit isolated drive power between the generator (130) and the drive module (120),
wherein the transformer module (140) comprises a primary coil (C1) connected to the generator (130), a secondary coil (C2) connected to the drive module (120), and a transformer core (TC) for mutual inductive coupling between the primary coil (C1) and the secondary coil (C2).

17. The switch stacking device (200) according to claim 16, wherein
the transformer core (TC) is a toroidal core with a through-hole (H) formed in a center thereof.
